Europäisches Patentamt

European Patent Office

Office européen des brevets

(19)

(11) **EP 0 674 770 B1**

(12) **EUROPÄISCHE PATENTSCHRIFT**

(45) Veröffentlichungstag und Bekanntmachung des Hinweises auf die Patenterteilung:
**08.05.1996 Patentblatt 1996/19**

(21) Anmeldenummer: **94901766.9**

(22) Anmeldetag: **16.12.1993**

(51) Int Cl.6: **G01R 33/06**

(86) Internationale Anmeldenummer:
**PCT/DE93/01205**

(87) Internationale Veröffentlichungsnummer:
**WO 94/15224 (07.07.1994 Gazette 1994/15)**

(54) **MAGNETOWIDERSTANDS-SENSOR MIT VERKÜRZTEN MESSSCHICHTEN**

MAGNETO-RESISTIVE SENSOR WITH SHORTENED MEASUREMENT LAYERS

DETECTEUR MAGNETO-RESISTIF COMPORTANT DES COUCHES DE MESURE RACCOURCIES

(84) Benannte Vertragsstaaten:
**AT BE CH DE ES FR GB IT LI NL SE**

(30) Priorität: **21.12.1992 DE 4243357**

(43) Veröffentlichungstag der Anmeldung:
**04.10.1995 Patentblatt 1995/40**

(73) Patentinhaber: **SIEMENS AKTIENGESELLSCHAFT**
**D-80333 München (DE)**

(72) Erfinder: **VAN DEN BERG, Hugo**
**D-91074 Herzogenaurach (DE)**

(56) Entgegenhaltungen:
**EP-A- 0 216 062        EP-A- 0 346 817**
**DE-A- 2 620 657**

- **IBM TECHNICAL DISCLOSURE BULLETIN., Bd.25, Nr.2, Juli 1982, NEW YORK US Seite 803 SHARMA ET AL. 'MR element position detector'**

## Beschreibung

Die Erfindung betrifft einen Magnetowiderstands-Sensor.

In ferromagnetischen Übergangsmetallen wie Nickel (Ni), Eisen (Fe) oder Kobalt (Co) und in Legierungen mit diesen Metallen ist der elektrische Widerstand abhängig von der Größe und Richtung eines das Material durchdringenden Magnetfeldes. Diesen Effekt nennt man anisotropen Magnetowiderstand (AMR) oder anisotropen magnetoresistiven Effekt. Er beruht physikalisch auf den unterschiedlichen Streuquerschnitten von Elektronen mit unterschiedlichem Spin, die entsprechend als Majoritäts- und Minoritätselektronen des D-Bandes bezeichnet werden. Für magnetoresistive Sensoren wird im allgemeinen eine dünne Schicht aus einem solchen magnetoresistiven Material mit einer Magnetisierung in der Schichtebene verwendet. Die Widerstandsänderung bei Drehung der Magnetisierung bezüglich der Stromrichtung kann einige Prozent des normalen isotropen Widerstandes betragen.

Es sind Mehrschichtsysteme bekannt mit mehreren, zu einem Stapel angeordneten ferromagnetischen Schichten, die durch metallische Zwischenschichten voneinander getrennt sind, und deren Magnetisierungen jeweils in der Schichtebene liegen. Die jeweiligen Schichtdicken sind dabei wesentlich kleiner als die mittlere freie Weglänge der Leitungselektronen gewählt. In solchen Schichtsystemen tritt nun zusätzlich zu dem anisotropen magnetoresistiven Effekt in den einzelnen Schichten der sogenannte Giant-magnetoresistive Effekt oder Giant-Magnetowiderstand (Giant-MR) auf, der auf der unterschiedlich starken Streuung von Majoritäts- und Minoritäts-Leitungselektronen im Volumen der Schichten, insbesondere in Legierungen, sowie an den Grenzflächen zwischen den ferromagnetischen Schichten und den Zwischenschichten beruht. Dieser Giant-MR ist ein isotroper Effekt und kann erheblich größer sein als der anisotrope MR mit Werten von bis zu 70 % des normalen isotropen Widerstandes.

Es sind zwei Grundtypen von solchen Giant-MR-Mehrschicht-systemen bekannt. Bei dem ersten Typ sind die ferromagnetischen Schichten über die Zwischenschichten antiferromagnetisch aneinander gekoppelt, so daß sich die in den Schichtebenen liegenden Magnetisierungen von zwei benachbarten ferromagnetischen Schichten ohne äußeres Magnetfeld antiparallel zueinander ausrichten. Ein Beispiel für diesen Typ sind Eisen-Chrom-Übergitter (Fe-Cr-Superlattices) mit ferromagnetischen Schichten aus Fe und antiferromagnetischen Zwischenschichten aus Cr. Durch ein äußeres Magnetfeld werden nun die Magnetisierungen von benachbarten ferromagnetischen Schichten gegen die antiferromagnetischen Kopplungskräfte gedreht und parallel ausgerichtet. Diese Umorientierung der Magnetisierungen durch das Magnetfeld hat eine stetige Abnahme des Giant-MR zur Folge, die ein Maß für die Größe des Magnetfeldes ist. Bei einer Sättigungsfeldstärke $H_s$

tritt keine Änderung des Giant-MR mehr auf, weil sämtliche Magnetisierungen dann parallel zueinander ausgerichtet sind. Der Giant-MR hängt dabei lediglich von dem Betrag der Feldstärke ab ("Physical Review Letters", Vol. 61, No. 21, November 1988, Seiten 2472 - 2475).

Für diesen Typ mit antiferromagnetisch gekoppelten, ferromagnetischen Schichten wurden auch theoretische Berechnungen durchgeführt, die eine Abhängigkeit der Strom- und der Transmissionskoeffizienten für an den Grenzflächen gestreute Elektronen mit Spin-up und solche mit Spin-down von dem Winkel zwischen den Magnetisierungen in benachbarten ferromagnetischen Schichten aufzeigen. Aus diesen Berechnungen ergibt sich, daß der Giant-MR bei von 0° auf 180° wachsendem Winkel zwischen den beiden Magnetisierungen stetig zunimmt und am größten bei einem Winkel von 180° ist ("Physical Review Letters", Vol. 63, No. 6, August 1989, Seiten 664 - 667).

Bei dem zweiten Typ eines Giant-MR-Mehrschichtsystems sind ferromagnetische Schichten mit zueinander im Mittel parallelen Magnetisierungen in den Schichtebenen durch dia- oder paramagnetische Zwischenschichten aus Metall voneinander getrennt. Die Zwischenschichten sind so dick gewählt, daß die magnetische Austauschkopplung zwischen den Magnetisierungen der ferromagnetischen Schichten möglichst gering ist. Jeweils benachbarte ferromagnetische Schichten weisen unterschiedliche Koerzitivfeldstärken auf. Dadurch werden die in der Sättigung zunächst parallelen Mittelwerte der Magnetisierungen $M_1$ und $M_2$ von magnetisch weicheren Meßschichten und benachbarten, magnetisch härteren Biasschichten durch ein Magnetfeld H unterschiedlich stark gedreht, und es stellt sich ein vom Magnetfeld H abhängiger Winkel Phi zwischen den Mittelwerten der Magnetisierungen $M_1$ und $M_2$ ein. Die Abhängigkeit der einzelnen Magnetisierungen $M_1$ und $M_2$ vom Magnetfeld H ergibt sich dabei aus den entsprechenden Hysteresekurven des magnetisch weicheren bzw. des magnetisch härteren Materials. Zwischen den Koerzitivfeldstärken $H_{cl}$ der magnetisch weicheren und $H_{c2}$ der magnetisch härteren Schichten und zwischen $-H_{c2}$ und $-H_{c1}$ liegt jeweils ein Bereich, in dem die Magnetisierung $M_1$ schon in Sättigung ist und die Magnetisierung $M_2$ noch ihren der Sättigung entsprechenden Wert hat und antiparallel zur Magnetisierung $M_1$ gerichtet ist, d.h. Phi = 180°. In diesem Bereich ist das MR-Signal maximal und konstant. Verschiedene Koerzitivfeldstärken $|H_{c1}| \leq |H_{c2}|$ kann man durch die Wahl unterschiedlicher Materialien oder durch unterschiedliche Herstellungsprozesse bzw. die Wahl unterschiedlicher Dicken des gleichen Materials einstellen. Bekannte Schichtstrukturen mit unterschiedlichen Materialien sind beispielsweise NiFe-Cu-Co-Schichtstrukturen und Fe-Cu-Co-Strukturen. Ein auf unterschiedlicher Herstellung oder unterschiedlichen Dicken beruhendes, bekanntes Schichtsystem ist ein Co-Au-Co-System ("Journal of Applied Physics", Vol. 70, No. 10, 15.

Nov. 1991, Seiten 5864 -5866). Das MR-Signal dieser bekannten Schichtsysteme hängt nun jedoch von ihrer Vorgeschichte ab, d.h. auf welchem Weg und zwischen welchen Werten für das Magnetfeld sowie in welcher Richtung die Hysteresekurven durchlaufen werden. Mit einem solchen Schichtsystem läßt sich daher kein MR-Sensor mit einer eindeutigen Kennlinie realisieren. Außerdem schließt sich bei diesen bekannten Schichtsystemen ein Teil des Magnetflusses der härteren Biasschichten über den weicheren Meßschichten. Dieses magnetische Störfeld verringert die Meßempfindlichkeit des Sensors und hat eine unerwünschte Verschiebung der Sensorkennlinie zur Folge.

Aus der EP-A-0 346 817 ist ein Magnetowiderstands-Sensor bekannt mit einem Schichtsystem aus einer ferromagnetischen Meßschicht und einer ferromagnetischen Biasschicht, die durch eine nichtmagnetische Zwischenschicht voneinander austauschentkoppelt sind, und mit Meßkontakten an dem Schichtsystem zum Anlegen eines elektrischen Stromes und Abgreifen einer Meßspannung, die ein Maß für ein anliegendes Magnetfeld ist. In einer ersten Ausführungsform dieses bekannten Magnetowiderstands-Sensors weist die Meßschicht eine kleinere Koerzitivfeldstärke auf als die Biasschicht. In einer zweiten Ausführungsform liegt dagegen an der Biasschicht eine antiferromagnetische Schicht an. Die Meßschicht weist somit eine im Meßbereich des Magnetfeldes reversibel vom Magnetfeld abhängende, drehbare Magnetisierung in der Schichtebene auf, während die Biasschicht eine in diesem Meßbereich konstante Magnetisierung in ihrer Schichtebene aufweist.

Der Erfindung liegt nun die Aufgabe zugrunde, einen Magnetowiderstands-Sensor mit einem Schichtsystem aus wenigstens einer Meßschicht und wenigstens einer durch eine Zwischenschicht von der Meßschicht austauschentkoppelten Biasschicht anzugeben, der eine eindeutige Kennlinie aufweist und bei dem Störfelder der Biasschicht in der Meßschicht weitgehend unterdrückt werden. Außerdem soll ein Magnetowiderstands-Sensor mit zumindest weitgehend linearer Kennlinie angegeben werden.

Diese Aufgabe wird gemäß der Erfindung gelöst mit den Merkmalen des Anspruchs 1.

Die Magnetisierung $\overline{M}_M$ der Meßschicht hängt wenigstens in einer Richtung reversibel und damit eindeutig vom zu messenden Magnetfeld ab, und im Grundzustand, d.h. wenn kein Magnetfeld anliegt, stellt sich die Magnetisierung $\overline{M}_M$ auf eine vorgegebene Grundzustandsmagnetisierung $\overline{M}_{MO}$ ein. Die Biasschicht ist mit einer im Meßbereich wenigstens annähernd konstanten Magnetisierung $\overline{M}_B$ versehen. Dadurch erhält man ein Widerstandssignal, das eindeutig von dem Magnetfeld abhängt.

Das Störfeld der Biasschicht in der Meßschicht kann im ungünstigsten Fall dazu führen, daß die Grundzustandsmagnetisierung $\overline{M}_{MO}$ in der Meßschicht schon antiparallel zur Magnetisierung $\overline{M}_B$ in der Biasschicht ausgerichtet wird, ohne daß ein Magnetfeld anliegt. Um zu verhindern, daß sich ein Teil des Magnetflusses der Biasschicht, insbesondere bei großem $\overline{M}_B$, über der Meßschicht schließt, ist die Meßschicht wenigstens in einer Richtung parallel zur Magnetisierung $\overline{M}_B$ der Biasschicht am Rand kürzer ausgebildet als die Biasschicht, so daß die Biasschicht die Meßschicht in dieser Richtung auf beiden Seiten überragt.

In einer vorteilhaften Ausführungsform ist die Meßschicht über ihren gesamten Randbereich kürzer ausgebildet als die Biasschicht.

Vorzugsweise werden die Übergänge zwischen den Randbereichen ohne Meßschicht und einem mittleren Meßbereich mit Meßschicht fließend gestaltet. Beispielsweise kann die Dicke der Meßschicht in diesen Übergangsbereichen zur Mitte hin kontinuierlich zunehmen.

Zur Messung des Widerstands des Schichtssystems sind wenigstens zwei Meßkontakte vorgesehen. Diese Meßkontakte können in einem Abstand voneinander vorzugsweise auf der obersten Schicht angeordnet sein, so daß der Meßstrom im Mittel parallel zu den Schichtebenen fließt (cip = current-in-planes). In einer anderen Ausführungsform sind die Meßkontakte auf der obersten und der untersten Schicht angeordnet, so daß der Meßstrom senkrecht zu den Schichtebenen fließt (cpp = current-perpendicular-to-planes). Ein Schichtsystem mit derartig angeordneten cpp-Meßkontakten ist aus "Physical Review B", Vol. 46, No. 1 (1992), Seiten 548 - 551 bekannt.

Die Meßschicht ist in einer vorteilhaften Ausführungsform mit einer magnetischen Vorzugsachse $A_M$ versehen. Die Meßschicht kann allerdings auch aus einem superparamagnetischen Material gewählt sein. Dann ist ihre Magnetisierung $\overline{M}_M$ in allen Richtungen reversibel vom Magnetfeld abhängig.

Wenn kein Magnetfeld anliegt, stellt sich eine Grundzustandsmagnetisierung $\overline{M}_{MO}$ der Meßschicht ein. Diese Grundzustandsmagnetisierung $\overline{M}_{MO}$ der Meßschicht ist nun in einer Ausführungsform parallel zur Magnetisierung $\overline{M}_B$ der Biasschicht gerichtet. Dazu wird die Meßschicht entlang einer parallel zur Magnetisierung $\overline{M}_B$ gerichteten Vorzugsachse magnetisiert.

In einer besonders vorteilhaften Ausführungsform sind die Grundzustandsmagnetisierung $\overline{M}_{MO}$ der Meßschicht und die feste Magnetisierung $\overline{M}_B$ der Biasschicht wenigstens annähernd senkrecht zueinander gerichtet. Dadurch wird der Arbeitspunkt des Sensors bei nicht vorhandenem Magnetfeld H = 0 in einem Bereich eingestellt, in dem die Kennlinie wenigstens annähernd linear ist und eine maximale Steigung aufweist.

Um die Magnetisierungen $\overline{M}_{MO}$ und $\overline{M}_B$ wenigstens annähernd senkrecht zueinander auszurichten, wird die Meßschicht vorzugsweise mit einer magnetischen Vorzugsachse $A_M$ versehen, die wenigstens annähernd senkrecht zur festen Magnetisierung $\overline{M}_B$ der Biasschicht gerichtet ist, und entlang dieser Vorzugsachse $A_M$ magnetisiert.

In einer anderen Ausführungsform wird die sogenannte 90°-Kopplung ausgenutzt. Die Dicke der Zwischenschicht wird auf einen Wert eingestellt, bei dem die magnetische Austauschkopplung zwischen Meßschicht und Biasschicht ihr Vorzeichen wechselt, d. h. von einer ferromagnetischen in eine antiferromagnetische Kopplung übergeht bzw. umgekehrt. Durch die statistischen Schwankungen der Dicke stellt sich nun die Grundzustandsmagnetisierung $\overline{M}_{MO}$ der Meßschicht im Mittel automatisch unter einem Winkel von 90° zur Magnetisierung $\overline{M}_B$ der Biasschicht ein.

Bei verschiedenen Materialien und verschiedener Geometrie der Schichten kann es zur Kompensation der entstehenden entmagnetisierenden Felder erforderlich sein, einen etwas von 90° abweichenden Winkel zwischen $\overline{M}_{MO}$ und $\overline{M}_B$ einzustellen, um den für Linearität und Empfindlichkeit des Sensors optimalen Arbeitspunkt zu erreichen.

Stärkere Abweichungen von der wenigstens annähernd senkrechten Ausrichtung der Magnetisierungen $\overline{M}_{MO}$ und $\overline{M}_B$ zueinander verschlechtern die Empfindlichkeit und die Linearität des Sensors.

Eine Ursache für solche störende Abweichungen des Winkels zwischen den beiden Magnetisierungen $\overline{M}_{MO}$ und $\overline{M}_B$ kann sein, wenn sich immer noch ein kleiner Rest des magnetischen Flusses der Biasschicht über der Meßschicht schließt. In einer weiteren Ausführungsform ist daher die Magnetisierung $|\overline{M}_B|$ der Biasschicht niedriger gewählt als die Grundzustandsmagnetisierung $|\overline{M}_{MO}|$ der Meßschicht.

Auch aufgrund von entmagnetisierenden Feldern vor allem in den Randbereichen der Schichten und insbesondere in der Biasschicht können Abweichungen von den vorgegebenen Richtungen für die Magnetisierungen $\overline{M}_{MO}$ und $\overline{M}_B$ auftreten. Deshalb sind in einer bevorzugten Ausführungsform die Meßkontakte zur Widerstandsmessung in einen inneren Meßbereich des Schichtsystems verlegt, um den Einfluß dieser Randbereiche auf das Meßsignal zu vermeiden.

In einer besonders vorteilhaften Ausführungsform sind die Schichten länglich ausgebildet, wobei ihre Längsrichtung senkrecht zur Grundzustandsmagnetisierung $\overline{M}_{MO}$ der Meßschicht verläuft. Dadurch ist die Lage der Magnetisierung $\overline{M}_B$ besonders stabil. Zudem erreicht man eine hohe Empfindlichkeit des Sensors und verringert die Verschiebung seiner Kennlinie, weil die von der Meßschicht bzw. der Biasschicht erzeugten entmagnetisierenden Felder stark abgeschwächt werden und ihr dem zu messenden Magnetfeld entgegenwirkender Einfluß verringert wird.

Zur Umlenkung des Magnetflusses der Meßschicht kann in einer weiteren Ausführungsform wenigstens eine Meßschicht durch zwei Meßschichten mit antiparallel zueinander gerichteten Magnetisierungen ersetzt werden, die durch eine Zwischenschicht getrennt sind. Vorzugsweise sind beide Magnetisierungen gegen die Normalenrichtung zur Magnetisierung $\overline{M}_B$ der Biasschicht unter etwa dem gleichen Winkel so geneigt, daß sie einen Winkel kleiner als 180° einschließen. Dadurch wird zusätzlich die Bildung von Domänen in den Meßschichten verringert.

Die bisher beschriebenen Ausführungsformen von Schichtsubsystemen können miteinander kombiniert werden und in einem Stapel aus einer Vielzahl solcher Subsysteme angeordnet werden. Die Magnetisierungen $\overline{M}_B$ der Biasschichten sind in allen Ausführungsformen gleich gerichtet. Die Grundzustandsmagnetisierungen $\overline{M}_{MO}$ der Meßschichten sind entweder kollinear oder senkrecht zu den Magnetisierungen $\overline{M}_B$ der Biasschichten gerichtet. Die Subsysteme sind jeweils durch eine weitere Zwischenschicht voneinander getrennt.

Zur näheren Erläuterung der Erfindung wird auf die Zeichnung Bezug genommen, in deren

FIG. 1 und 2 jeweils eine Ausführungsform eines Magnetowiderstands-Sensors mit Randbereichen ohne Meßschicht gemäß der Erfindung im Querschnitt,

FIG. 3 eine Ausführungsform mit nach innen verlegten Meßkontakten in der Draufsicht und

FIG. 4 eine Ausführungsform mit zwei benachbarten Meßschichten im Querschnitt

schematisch dargestellt sind.

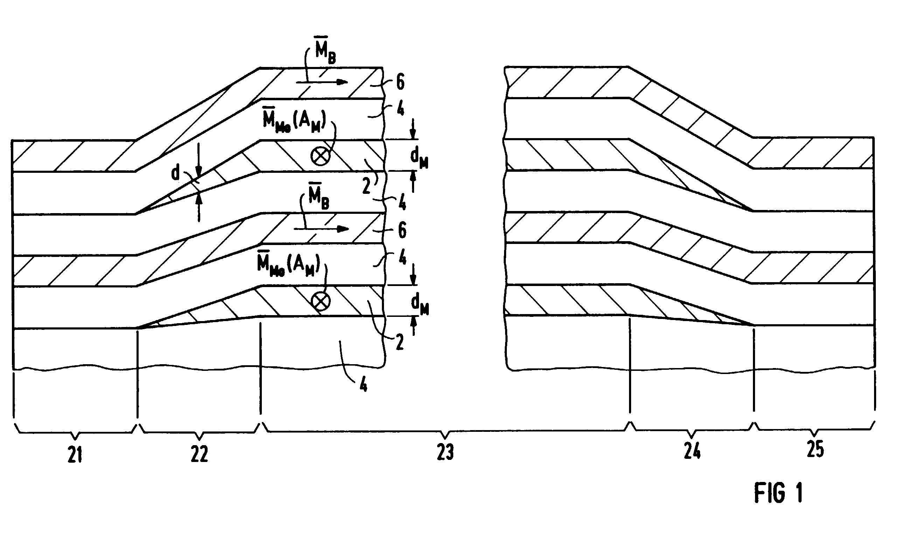

FIG. 1 zeigt eine Ausführungsform eines Magnetowiderstand-Sensors mit mehreren magnetischen Meßschichten 2 und mehreren magnetischen Biasschichten 6, von denen jeweils nur zwei dargestellt sind, sowie jeweils zwischen einer Meßschicht 2 und einer Biasschicht 6 angeordneten, nichtmagnetischen Zwischenschichten 4. Alle Schichten bestehen aus einem elektrisch leitendem Material, und ihre Dicken sind wesentlich kleiner als die mittlere freie Weglänge der Leitungselektronen. Die Meßschichten 2 weisen zueinander parallele und vorzugsweise gleich große Grundzustandsmagnetisierungen $\overline{M}_{MO}$ entlang von Vorzugsachsen auf, die mit $A_M$ bezeichnet sind und in den Schichtebenen der Meßschichten 2 verlaufen. Die Biasschichten 6 sind mit zueinander parallelen und vorzugsweise gleich großen festen Magnetisierungen $\overline{M}_B$ in ihren Schichtebenen versehen, die wenigstens annähernd senkrecht zu den Vorzugsachsen $A_M$ der Meßschicht 2 gerichtet sind und in der Zeichenebene dargestellt sind. Die Magnetisierungen $\overline{M}_B$ können allerdings auch umgekehrt gerichtet sein. Durch die wenigstens annähernd orthogonale Ausrichtung der Vorzugsachsen $A_M$ und damit der Grundzustandsmagnetisierungen $\overline{M}_{MO}$ relativ zu den Magnetisierungen $\overline{M}_B$ liegt der Arbeitspunkt des Sensors in dieser bevorzugten Ausführungsform in einem wenigstens annähernd linearen Bereich der Kennlinie mit zugleich der größten Steigung. Der Winkel zwischen den Magnetisierungen $\overline{M}_{MO}$ und $\overline{M}_B$ kann zur Kompensation von entmagnetisierenden Feldern etwas von 90° abweichen.

Wird nun ein in FIG. 1 nicht dargestelltes Magnetfeld $\overline{H}$ in der Schichtebene angelegt, dann ändern sich

die Magnetisierungen $\overline{M}_M$ in den Meßschichten 2 aus den Grundzustandsmagnetisierungen $\overline{M}_{MO}$, und die Magnetisierungen $\overline{M}_B$ der Biasschichten 6 bleiben im wesentlichen unverändert. Eine Komponente $\overline{H}_V$ des Magnetfeldes $\overline{H}$ senkrecht zu den Vorzugsachsen $A_M$ der Meßschichten 2 dreht die Magnetisierungen $\overline{M}_M$ der Meßschichten 2 in Richtung zu den Magnetisierungen $\overline{M}_B$ bzw. $-\overline{M}_B$, entsprechend der Feldrichtung $\overline{H}$. In der Sättigung sind die Magnetisierungen $\overline{M}_M$ und $\overline{M}_B$ dann parallel bzw. antiparallel zueinander gerichtet. Dieser Drehprozeß erzeugt ein Giant-Magnetowiderstandssignal in Abhängigkeit vom Drehwinkel. Eine Komponente $\overline{H}_p$ des Magnetfeldes $\overline{H}$ parallel zu den Vorzugsachsen $A_M$ dagegen bewirkt eine Domänenwandverschiebung und somit lediglich eine Richtungsumkehr der Magnetisierungen $\overline{M}_M$ an den Domänenwänden. Ein Magnetowiderstandssignal wird dadurch nicht erzeugt. Bei einem Magnetfeld senkrecht zur Schichtebene finden wegen der hohen entmagnetisierenden Felder in den Meßschichten 2 ebenfalls praktisch keine Drehprozesse statt, und damit wird auch kein Magnetowiderstandssignal gemessen. Der Magnetowiderstands-Sensor ist also im wesentlichen nur empfindlich für die Komponente $\overline{H}_V$ des Magnetfeldes $\overline{H}$, die orthogonal zu den Vorzugsachsen $A_M$ in dieser Ausführungsform bzw. allgemein zu den Grundzustandsmagnetisierungen $\overline{M}_{MO}$ der Meßschichten 2 gerichtet ist.

Die Magnetisierungen $\overline{M}_B$ der Biasschichten 6 sollen in dem Meßbereich des anliegenden Feldes $\overline{H}$ konstant bleiben und insbesondere sich nicht in der Schichtebene drehen. Dazu kann in einer Ausführungsform in die Biasschichten jeweils eine magnetische, uniaxiale Anisotropie, insbesondere eine Kristallanisotropie, eine feldinduzierte Anisotropie oder eine spannungsinduzierte Anisotropie, eingeprägt werden.

Die Biasschichten werden dann entlang ihrer Anisotropieachse magnetisiert.

Vorzugsweise sind mehrere Schichtsubsysteme aus Meßschicht, Zwischenschicht und Biasschicht vorgesehen, die durch jeweils eine Zwischenschicht getrennt und in einem periodischen Stapel angeordnet sind. Die Zahl dieser Schichtsubsysteme wird im allgemeinen zwischen 1 und 100 gewählt.

Zur Widerstandsmessung sind, vorzugsweise auf der obersten Schicht des Schichtssystems, zwei Meßkontakte in einem Abstand zueinander angeordnet, der vorzugsweise wesentlich größer als die Dicke des Schichtsystems ist (cip). In einer anderen Ausführungsform sind die Meßkontakte auf der Oberseite und der Unterseite des Schichtsystems angeordnet (cpp). Ihr Abstand entspricht dann der Dicke des Schichtsystems. Typische Dicken des gesamten Schichtssystems liegen zwischen 3 nm und 400 nm und typische Abstände der Meßkontakte in einem Bereich von 3 nm bis 1 mm. Zwischen den beiden - in FIG. 1 nicht dargestellten - Meßkontakten bildet sich in dem gesamten Schichtssystem ein elektrischer Strom von Leitungselektronen aus.

Die Meßschichten 2 sind nun zur magnetostatischen Entkopplung von den Biasschichten 6 in Richtung von deren Magnetisierungen $\overline{M}_B$ am Rand kürzer ausgebildet als die Biasschichten 6. Das Schichtsystem ist somit mit zwei Randbereichen 21 und 25 versehen, in denen keine Meßschicht 2 vorhanden ist, und mit einem mittlerer Meßbereich 23 mit Meßschichten 2. Diese Verkürzung der Meßschichten 2 wird wenigstens in Richtung parallel zur Magnetisierung $\overline{M}_B$ der Biasschicht 6 und vorzugsweise in allen Richtungen vorgenommen, so daß die Biasschichten 6 ringsum über die Meßschichten 2 hinausragen. Die Zwischenschichten 4 sind vorzugsweise so lang wie die Biasschichten 6.

Zwischen den Randbereichen 21 und 25 und dem Meßbereich 23 ist in dieser Ausführungsform jeweils ein Übergangsbereich 22 bzw. 24 vorgesehen, in dem die Dicke d der Meßschichten 2 von außen nach innen kontinuierlich zunimmt. Während die Biasschichten 6 und die Zwischenschichten 4 in den Übergangsbereichen 22 und 24 wenigstens annähernd genauso dick sind wie in den Randbereichen 21 und 25 sowie im Meßbereich 23, nehmen die Dicken d der Meßschichten 2 in den Übergangsbereichen 22 und 24 unter einem bestimmten Öffnungswinkel von d=0 in den Randbereichen 21 und 25 bis zu einem konstanten Wert $d=d_M$ im Meßbereich 23 linear zu.

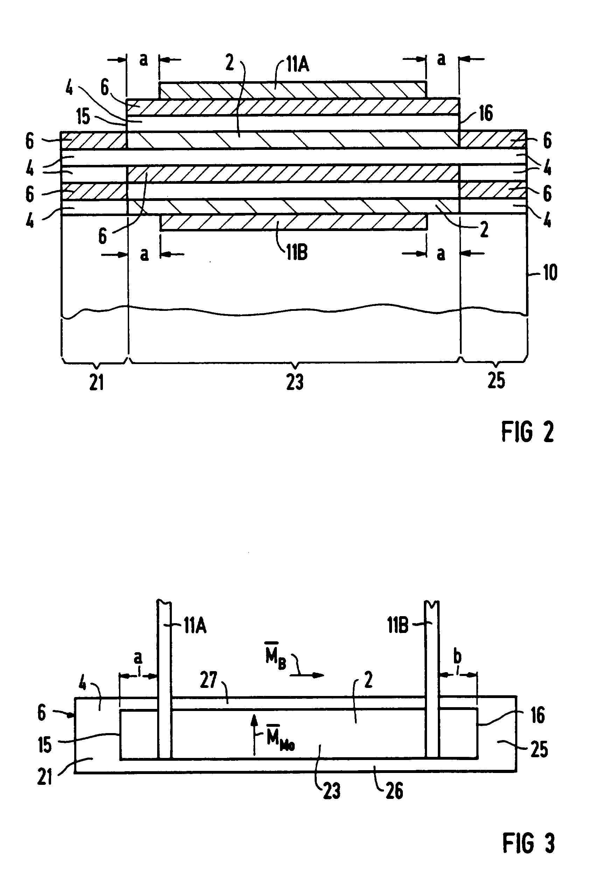

In einer einfachen Ausführungsform gemäß FIG. 2 sind zwischen den Randbereichen 21 und 25 und dem Meßbereich 23 keine Übergangsbereiche, sondern jeweils eine Stufe vorgesehen, deren Höhe der Gesamtdicke der in den Randbereichen 21 und 25 fehlenden Meßschichten 2 entspricht. Der Schichtaufbau in den Randbereichen 21 und 25 ergibt sich dabei vorzugsweise durch Weglassen der Meßschichten 2 und kann durch ein entsprechendes Lithographieverfahren hergestellt werden. Das Schichtsystem ist auf einem Substrat 10 angeordnet. Ein solches Substrat 10 ist vorzugsweise auch in allen andern Ausführungsformen vorgesehen. Es sind zwei Meßkontakte 11A und 11B auf der obersten bzw. der untersten Schicht in einer cpp-Anordnung vorgesehen. Der Strom fließt dann zwischen diesen beiden Meßkontakten 11A und 11B im Mittel senkrecht zu den Schichtebenen. Die Meßkontakte 11A und 11B sind jeweils in einem vorzugsweise gleichen Abstand a von den Enden 15 und 16 des Meßbereichs 23 beabstandet, um störende Randeffekte aufgrund von entmagnetisierenden Feldern an diesen Enden 15 und 16 auf das Meßsignal zu umgehen.

In einer vorteilhaften Ausführungsform, die in FIG. 3 in der Draufsicht dargestellt ist, sind die Schichten als rechteckige Streifen ausgebildet, deren Längsrichtung senkrecht zur Grundzustandsmagnetisierung $\overline{M}_{MO}$ der Meßschicht 2 verläuft. Durch diese Maßnahme werden die dem Meßfeld entgegengesetzt gerichteten entmagnetisierenden Felder deutlich abgeschwächt und somit die Empfindlichkeit des Sensors erhöht sowie eine Verschiebung der Meßkennlinie vermieden. Die Meßschicht 2 ist nun nicht nur in Richtung der Magne-

tisierung $\overline{M}_B$, sondern auch in Normalenrichtung zu $\overline{M}_B$ auf beiden Seiten kürzer ausgebildet als die Biasschicht 6. Der Meßbereich 23 des Schichtsystems mit Meßschicht 2 hat in der dargestellten senkrechten Projektion bezüglich der Schichtebenen somit die Form eines Rechtecks, das ganz innerhalb des durch das gesamte Schichtsystem ohne Meßschicht 2, d.h. den Meßbereich 23 und die Randbereiche 21, 25, 26 und 27, gebildeten Rechtecks liegt. Zur Widerstandsmessung sind in einer cip-Anordnung Meßkontakte 11A und 11B vorgesehen. Diese Meßkontakte 11A und 11B sind vorzugsweise zur Vermeidung von Störeinflüssen durch entmagnetisierende Felder an den Enden 15 und 16 des Meßbereichs 23 in Längsrichtung um einen Abstand a bzw. b nach innen in den Meßbereich 23 versetzt angeordnet. Vorzugsweise sind beide Abstände a und b gleich groß. Die Meßkontakte 11A und 11B sind vorzugsweise auf der Meßschicht 2 angeordnet, können aber auch entsprechend auf einer Biasschicht 6 oder einer Zwischenschicht 4 angeordnet sein.

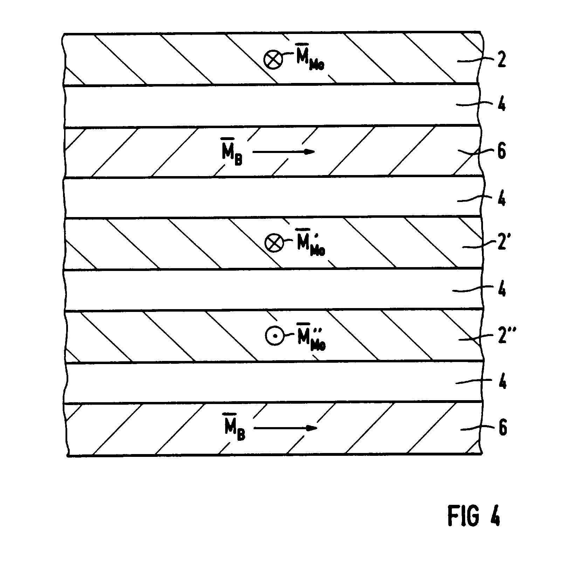

In FIG. 4 ist eine besondere Ausführungsform des Meßbereichs 23 des Sensors dargestellt, in der wenigstens eine Meßschicht 2 durch zwei Meßschichten 2' und 2" ersetzt ist. Die Grundzustandsmagnetisierungen $\overline{M}_{MO}'$ und $\overline{M}_{MO}"$ dieser beiden Meßschichten 2' und 2" sind nun vorzugsweise durch Einprägen entsprechender Vorzugsachsen antiparallel zueinander gerichtet und vorzugsweise gleich groß, d.h. $\overline{M}_{MO}' = -\overline{M}_{MO}"$. Damit bleibt der Magnetfluß der Meßschichten 2' und 2" im wesentlichen auf die Meßschichten 2' und 2" selbst beschränkt und greift nicht auf die benachbarten Biasschichten 6 über. Die Biasschichten 6 sind jeweils mit gleichgerichteten Magnetisierungen $\overline{M}_B$ versehen, die zuzumindest annähernd senkrecht zu den Grundzustandsmagnetisierungen $\overline{M}_{MO}'$ und $\overline{M}_{MO}"$ der Meßschichten 2' bzw. 2" gerichtet sind.

Wegen Schwankungen in den Richtungen der Vorzugsachsen und einem daraus resultierenden nicht eindeutigen Drehsinn für die Magnetisierungen $\overline{M}_M'$ und $\overline{M}_M"$ aus den Grundzustandsmagnetisierungen $\overline{M}_{MO}'$ bzw. $\overline{M}_{MO}"$ bilden sich im allgemeinen nach Sättigung in den Meßschichten 2' und 2" bei kleineren Feldwerten Domänen. In einer besonderen, nicht dargestellten Ausführungsform sind die Grundzustandsmagnetisierungen $\overline{M}_{MO}'$ und $\overline{M}_{MO}"$ der beiden Meßschichten 2' bzw. 2" zur Vermeidung dieser Domänenbildung jeweils um einen kleinen Winkel gegen die Normalenrichtung zur Magnetisierung $\overline{M}_B$ der Biasschichten 6 in unterschiedlichem Drehsinn eingestellt, so daß sie einen Winkel von etwas weniger als 180° miteinander einschließen. Dies kann durch Einprägen entsprechend zueinander geneigter Vorzugsachsen in die entsprechenden Meßschichten 2' und 2" erreicht werden. Dadurch ist für jede der beiden Magnetisierungen $\overline{M}_M'$ und $\overline{M}_M"$ bei Anliegen eines Magnetfeldes $\overline{H}$ ein eindeutiger Drehsinn aus der Sättigung vorgegeben.

Als magnetische Materialien für die Meßschichten können beispielsweise Co, Fe, Ni, SmCo oder auch Tb-

FeCo und für die Biasschichten $Ni_{80}Fe_{20}$ oder auch $Ni_{66}CoFe$ vorgesehen sein. Die Zwischenschichten bestehen vorzugsweise aus Cu, Au, Ag oder Cr.

**Patentansprüche**

1. Magnetowiderstands-Sensor mit

   a) einem Schichtsystem, das

      a1) wenigstens eine Meßschicht (2), die in der Schichtebene eine Magnetisierung ($\overline{M}_M$) aufweist, die wenigstens in einer Richtung reversibel von einem anliegenden Magnetfeld ($\overline{H}$) abhängt und bei fehlendem Magnetfeld ($\overline{H}$) einer vorgegebenen Grundzustandsmagnetisierung ($\overline{M}_{MO}$) entspricht, und das

      a2) auf wenigstens einer Seite der Meßschicht (2) eine Biasschicht (6) mit einer im Meßbereich des Magnetfeldes ($\overline{H}$) wenigstens annähernd konstanten Magnetisierung ($M_B$) in der Schichtebene enthält, wobei

      a3) die Biasschicht (6) von der Meßschicht (2) durch eine Zwischenschicht (4) wenigstens annähernd magnetisch austauschentkoppelt ist,

   und mit

   b) Meßkontakten (11A und 11B) an dem Schichtsystem zum Erfassen eines Widerstandssignals, das ein Maß für das anliegende Magnetfeld ($\overline{H}$) ist,

   **dadurch gekennzeichnet**, daß

   c) das Schichtsystem wenigstens in einer parallel zur Magnetisierung ($\overline{M}_B$) der Biasschicht (6) verlaufenden Richtung Randbereiche (21, 25) ohne Meßschicht (2) aufweist.

2. Magnetowiderstands-Sensor nach Anspruch 1, **dadurch gekennzeichnet**, daß der Rand der Meßschicht (2) innerhalb der von der Biasschicht (6) eingenommenen Fläche liegt.

3. Magnetowiderstands-Sensor nach Anspruch 1 oder 2, **dadurch gekennzeichnet**, daß die Dicke der Meßschicht (2) in Übergangsbereichen (22 und 24) zwischen den Randbereichen (21 bzw. 25) des Schichtsystems ohne die Meßschicht (2) und einem inneren Meßbereich (23) mit der Meßschicht (2) kontinuierlich zunimmt.

4. Magnetowiderstands-Sensor nach einem der vorhergehenden Ansprüche, **dadurch gekennzeichnet**, daß die Grundzustandsmagnetisierung ($\overline{M}_{MO}$) der Meßschicht (2) und die Magnetisierung ($\overline{M}_B$)

der Biasschicht (6) wenigstens annähernd senkrecht zueinander gerichtet sind.

5. Magnetowiderstands-Sensor nach einem der Ansprüche 1 bis 3, **dadurch gekennzeichnet**, daß die Grundzustandsmagnetisierung ($\overline{M}_{MO}$) der Meßschicht (2) und die Magnetisierung ($\overline{M}_B$) der Biasschicht (6) parallel zueinander gerichtet sind.

6. Magnetowiderstands-Sensor nach einem der vorhergehenden Ansprüche, **dadurch gekennzeichnet**, daß die Magnetisierung ($\overline{M}_B$) der Biasschicht (6) betragsmäßig kleiner gewählt ist als die Grundzustandsmagnetisierung ($\overline{M}_{MO}$) der Meßschicht (2).

7. Magnetowiderstands-Sensor nach einem der vorhergehenden Ansprüche, **dadurch gekennzeichnet**, daß die Meßschicht (2) und die Biasschicht (6) in einer Längsrichtung senkrecht zur Grundzustandsmagnetisierung ($\overline{M}_{MO}$) der Meßschicht (2) bevorzugt ausgedehnt sind.

8. Magnetowiderstands-Sensor nach einem der vorhergehenden Ansprüche, **dadurch gekennzeichnet**, daß die Meßkontakte (11A und 11B) vom Rand des Schichtsystems beabstandet angeordnet sind.

9. Magnetowiderstands-Sensor nach einem der vorhergehenden Ansprüche, **dadurch gekennzeichzet**, daß die Meßkontakte auf der obersten und/oder der untersten Schicht des Schichtsystems angeordnet sind.

10. Magnetowiderstands-Sensor nach einem der vorhergehenden Ansprüche, **dadurch gekennzeichnet**, daß wenigstens eine Meßschicht (2) durch zwei Meßschichten (2' und 2") ersetzt ist, die durch eine Zwischenschicht (4) magnetisch austauschkoppelt sind.

11. Magnetowiderstands-Sensor nach Anspruch 10, **dadurch gekennzeichnet**, daß die Grundzustandsmagnetisierungen ($M_{MO}'$ und $M_{MO}''$) der beiden Meßschichten (2' und 2") wenigstens annähernd antiparallel zueinander gerichtet sind, wenn kein Magnetfeld ($\overline{H}$) anliegt.

12. Magnetowiderstands-Sensor nach Anspruch 10, **dadurch gekennzeichnet**, daß die Grundzustandsmagnetisierungen ($\overline{M}_{MO}'$ und $\overline{M}_{MO}''$) der beiden Meßschichten (2' und 2") um jeweils wenigstens annähernd den gleichen Winkel gegen die Normalenrichtung zur Magnetisierung ($\overline{M}_B$) der Biasschicht (6) geneigt sind und einen Winkel von weniger als 180° miteinander einschließen, wenn kein Magnetfeld ($\overline{H}$) anliegt.

13. Magnetowiderstands-Sensor nach einem der vorhergehenden Ansprüche, **dadurch gekennzeichnet**, daß jede Meßschicht (2, 2', 2") bei fehlendem Magnetfeld ($\overline{H}$) in Richtung einer Vorzugsachse magnetisiert ist.

14. Magnetowiderstands-Sensor nach einem der vorhergehenden Ansprüche, **dadurch gekennzeichnet**, daß die Biasschicht (6) entlang einer Vorzugsachse magnetisiert ist.

15. Magnetowiderstands-Sensor nach einem der vorhergehenden Ansprüche, **dadurch gekennzeichnet**, daß mehrere aus jeweils einer Meßschicht (2), einer Zwischenschicht (4) und einer Biasschicht (6) gebildete Schichtsysteme so übereinander angeordnet sind, daß sich eine periodische Schichtfolge ergibt, und jeweils durch eine Zwischenschicht (4) voneinander getrennt sind.

## Claims

1. Magnetoresistive sensor comprising

 a) a layer system which comprises

  a1) at least one measuring layer (2) which, in the plane of the layer, has a magnetization ($\overline{M}_M$) which at least in one direction depends reversibly on a magnetic field ($\overline{H}$) applied and, if the magnetic field ($\overline{H}$) is absent, corresponds to a predefined ground state magnetization ($\overline{M}_{MO}$); and
  a2) at least on one side of the measuring layer (2) a bias layer (6) having a magnetization ($M_B$) in the plane of the layer, which magnetization is at least approximately constant in the measuring range of the magnetic field ($\overline{H}$),
  a3) the bias layer (6) being at least approximately magnetically exchange-decoupled from the measuring layer (2) by an interlayer (4),

 and
 b) measuring contacts (11A and 11B) on the layer system to detect a resistance signal which is a measure for the magnetic field ($\overline{H}$) applied, characterized in that
 c) the layer system is provided, at least in a direction running parallel to the magnetization ($\overline{M}_B$) of the bias layer (6), with boundary zones (21, 25) not having a measuring layer (2).

2. Magnetoresistive sensor according to Claim 1, characterized in that the boundary of the measuring layer (2) is situated within the area occupied by the bias layer (6).

3. Magnetoresistive sensor according to Claim 1 or 2, characterized in that the thickness of the measuring layer (2) in transition zones (22 and 24) between the boundary zones (21 and 25, respectively) of the layer system without the measuring layer (2) and an inner measuring zone (23) with the measuring layer (2) increases continuously.

4. Magnetoresistive sensor according to any one of the preceding claims, characterized in that the ground state magnetization ($\overline{M}_{MO}$) of the measuring layer (2) and the magnetization ($\overline{M}_B$) of the bias layer (6) are aligned at least approximately perpendicular to each other.

5. Magnetoresistive sensor according to any one of Claims 1 to 3, characterized in that the ground state magnetization ($\overline{M}_{MO}$) of the measuring layer (2) and the magnetization ($\overline{M}_B$) of the bias layer (6) are aligned parallel to each other.

6. Magnetoresistive sensor according to any one of the preceding claims, characterized in that the magnitude of the magnetization ($\overline{M}_B$) of the bias layer (6) is chosen to be smaller than that of the ground state magnetization ($\overline{M}_{MO}$) of the measuring layer (2).

7. Magnetoresistive sensor according to any one of the preceding claims, characterized in that the measuring layer (2) and the bias layer (6) are preferentially extended in a longitudinal direction perpendicular to the ground state magnetization ($\overline{M}_{MO}$) of the measuring layer (2).

8. Magnetoresistive sensor according to any one of the preceding claims, characterized in that the measuring contacts (11A and 11B) are arranged so as to be at a distance from the boundary of the layer system.

9. Magnetoresistive sensor according to any one of the preceding claims, characterized in that the measuring contacts are arranged on the uppermost and/or the lowermost layer of the layer system.

10. Magnetoresistive sensor according to any one of the preceding claims, characterized in that at least one measuring layer (2) has been replaced by two measuring layers (2' and 2") which are magnetically exchange-decoupled by an interlayer (4).

11. Magnetoresistive sensor according to Claim 10, characterized in that the ground state magnetizations ($M_{MO}'$ and $M_{MO}''$) of the two measuring layers (2' and 2") are aligned at least approximately antiparallel with respect to one another, if no magnetic field ($\overline{H}$) is applied.

12. Magnetoresistive sensor according to Claim 10, characterized in that the ground state magnetizations ($\overline{M}_{MO}'$ and $\overline{M}_{MO}''$) of the two measuring layers (2' and 2") are each inclined by at least approximately the same angle with respect to the direction of the normal to the magnetization ($\overline{M}_B$) of the bias layer (6) and between one another enclose an angle of less than 180°, if no magnetic field ($\overline{H}$) is applied.

13. Magnetoresistive sensor according to any one of the preceding claims, characterized in that each measuring layer (2, 2', 2") is magnetized in the direction of a preferred axis if no magnetic field ($\overline{H}$) is present.

14. Magnetoresistive sensor according to any one of the preceding claims, characterized in that the bias layer (6) is magnetized along a preferred axis.

15. Magnetoresistive sensor according to any one of the preceding claims, characterized in that a plurality of layer systems, which are each formed from a measuring layer (2), an interlayer (4) and a bias layer (6), are arranged above one another in such a way that a periodic layer sequence results and are separated from one another in each case by an interlayer (4).

**Revendications**

1. Capteur à magnétorésistance comportant

    a) un système de couches, qui

        a1) comporte au moins une couche de mesure (2), qui a, dans son plan, une aimantation ($\overline{M}_M$), qui, au moins dans une direction, dépend d'une manière réversible d'un champ magnétique appliqué ($\overline{H}$) et correspond, en absence de champ magnétique ($\overline{H}$), à une aimantation prescrite d'état de base ($\overline{M}_{MO}$) et
        a2) comprend, sur au moins une face de la couche de mesure (2), une couche de polarisation (6) ayant une aimantation ($M_B$) au moins approximativement constante dans la zone de mesure du champ magnétique ($\overline{H}$) et située dans le plan de la couche,
        a3) la couche de polarisation (6) étant au moins approximativement découplée magnétiquement, selon un découplage d'échange, vis-à-vis de la couche de mesure (2) par une couche intercalaire (4), et comportant

b) des contacts de mesure (11A et 11B) disposés sur le système de couches pour détecter un signal de résistance, qui est une mesure du champ magnétique ($\overline{H}$) appliqué,
caractérisé par le fait que
c) le système de couches comporte, au moins dans une direction qui est parallèle à l'aimantation ($\overline{M}_B$) de la couche de polarisation (6), des zones marginales (21,25) sans couche de mesure (2).

2. Capteur à magnétorésistance suivant la revendication 1, caractérisé par le fait que le bord de la couche de mesure (2) est à l'intérieur de la surface occupée par la couche de polarisation (6).

3. Capteur à magnétorésistance suivant la revendication 1 ou 2,
caractérisé par le fait que l'épaisseur de la couche de mesure (2) dans les zones de jonction (22 et 24) entre les zones marginales (21 ou 25) du système de couches sans la couche de mesure (2) et une zone intérieure de mesure (23) ayant la couche de mesure (2) augmente continûment.

4. Capteur à magnétorésistance suivant l'une des revendications précédentes, caractérisé par le fait que l'aimantation d'état de base ($\overline{M}_{MO}$) de la couche de mesure (2) et l'aimantation ($\overline{M}_B$) de la couche de polarisation (6) sont au moins approximativement perpendiculaires entre elles.

5. Capteur à magnétorésistance suivant l'une des revendications 1 à 3, caractérisé par le fait que l'aimantation d'état de base ($\overline{M}_{MO}$) de la couche de mesure (2) et l'aimantation ($\overline{M}_B$) de la couche de polarisation (6) sont parallèles l'une à l'autre.

6. Capteur à magnétorésistance suivant l'une des revendications précédentes, caractérisé par le fait que le module de l'aimantation ($\overline{M}_B$) de la couche de polarisation (6) est choisie inférieure à celui de l'aimantation d'état de base ($\overline{M}_{MO}$) de la couche de mesure (2).

7. Capteur à magnétorésistance suivant l'une des revendications précédentes, caractérisé par le fait que la couche de mesure (2) et la couche de polarisation (6) sont élargies de préférence dans une direction longitudinale perpendiculairement à l'aimantation d'état de base ($\overline{M}_{MO}$) de la couche de mesure (2).

8. Capteur à magnétorésistance suivant l'une des revendications précédentes, caractérisé par le fait que les contacts de mesure (11A et 11B) sont disposés à distance du bord du système de couches.

9. Capteur à magnétorésistance suivant l'une des revendications précédentes, caractérisé par le fait que les contacts de mesure sont disposés sur la couche la plus haute et/ou sur la couche la plus basse du système de couches.

10. Capteur à magnétorésistance suivant l'une des revendications précédentes, caractérisé par le fait qu'au moins une couche de mesure (2) est remplacée par deux couches de mesure (2' et 2"), qui ont un découplage magnétique d'échange au moyen d'une couche intercalaire (4).

11. Capteur à magnétorésistance suivant la revendication 10, caractérisé par le fait que les aimantations d'état de base ($M_{MO}'$ et $M_{MO}"$) des deux couches de mesure (2' et 2") sont dirigées au moins approximativement d'une manière antiparallèle, lorsqu'aucun champ magnétique ($\overline{H}$) n'est appliqué.

12. Capteur à magnétorésistance suivant la revendication 7, caractérisé par le fait que les aimantations d'état de base ($\overline{M}_{MO}'$ et $\overline{M}_{MO}"$) des deux couches de mesure (2' et 2") sont inclinées chacune au moins approximativement du même angle par rapport à la direction normale à l'aimantation ($\overline{M}_B$) de la couche de polarisation (6) et font entre elles un angle inférieur à 180°, lorsqu'aucun champ magnétique ($\overline{H}$) n'est appliqué.

13. Capteur à magnétorésistance suivant l'une des revendications précédentes, caractérisé par le fait que chaque couche de mesure (2, 2', 2") est aimantée dans la direction d'un axe préférentiel, en absence de champ magnétique ($\overline{H}$) .

14. Capteur à magnétorésistance suivant l'une des revendications précédentes, caractérisé par le fait que la couche de polarisation (6) est aimantée le long d'un axe préférentiel.

15. Capteur à magnétorésistance suivant les revendications précédentes, caractérisé par le fait que plusieurs systèmes de couches, constitués chacun d'une couche de mesure (2), d'une couche intercalaire (4) et d'une couche de polarisation (6), sont disposés en superposition de manière à former une succession périodique de couches, et sont séparées les uns des autres chacun par une couche intercalaire (4).

FIG 1

FIG 2

FIG 3

FIG 4